# EUROPEAN PATENT APPLICATION

(11) **EP 3 952 082 A1**
(43) Date of publication of application: **09.02.2022**
(21) Application number: 19920716.8
(22) Date of filing: 05.12.2019
(51) Int. Cl.: H02M 1/08, H02M 7/5387, H03K 17/14, H03K 17/16, H01L 29/739, H01L 29/78

(54) **SEMICONDUCTOR DEVICE, POWER CONVERSION DEVICE USING SAME, AND DRIVING METHOD FOR SEMICONDUCTOR DEVICE**

(30) Priority: 27.03.2019 JP 2019060329
(71) Applicant: Hitachi, Ltd., Tokyo 100-8280 (JP)
(72) Inventor: MIYOSHI, Tomoyuki, Tokyo 100-8280 (JP); FURUKAWA, Tomoyasu, Tokyo 100-8280 (JP); TAKEUCHI, Yujiro, Tokyo 100-8280 (JP); SUZUKI, Hiroshi, Tokyo 100-8280 (JP); SHIRAISHI, Masaki, Tokyo 100-8280 (JP)
(74) Representative: Mewburn Ellis LLP
(86) International application number: PCT/JP2019/047570
(87) International publication number: WO 2020/194887

(57) **Abstract**

In order to provide a semiconductor device that has low loss performance and that enables stable dv_{CE}/dt switching with respect to temperature and conduction conditions, this semiconductor device is composed of a dual-gate IGBT having a first gate terminal and a second gate terminal. During transitioning from a non-conduction state of the dual-gate IGBT to a conduction state, a voltage of a threshold voltage or greater is applied to the first gate terminal at a first prescribed time which precedes the time for application to the second gate terminal. During transitioning from the conduction state of the dual-gate IGBT to the non-conduction state, a voltage that is below the threshold voltage is applied to the second gate terminal at a second prescribed time which precedes the time for application to the first gate terminal. The first and second prescribed times are variably controlled such that the change over time of the collector-emitter voltage of the dual-gate IGBT, which occurs during the transitioning from the non-conduction state to the conduction state and during the transitioning from the conduction state to the non-conduction state, is substantially consistent.

## Description

### Technical Field

The present invention relates to a semiconductor device and a power converter using the same, and more particularly suitable for a power converter applied to electric power devices from low electric power devices such as air conditioners and microwave ovens to high electric power devices such as inverters for railroads and iron mills.

### Background Art

Global warming is an important, urgent problem common throughout the world, and as one of the measures, the expectation of contribution of power electronic techniques is increasing. In particular, for achieving high efficiency of inverters responsible for electric power conversion functions, power semiconductor devices are demanded to decrease power consumption, the power semiconductor devices being mainly composed of IGBTs (Insulated Gate Bipolar Transistors) serving as a power switching function and diodes serving as a rectifier function.

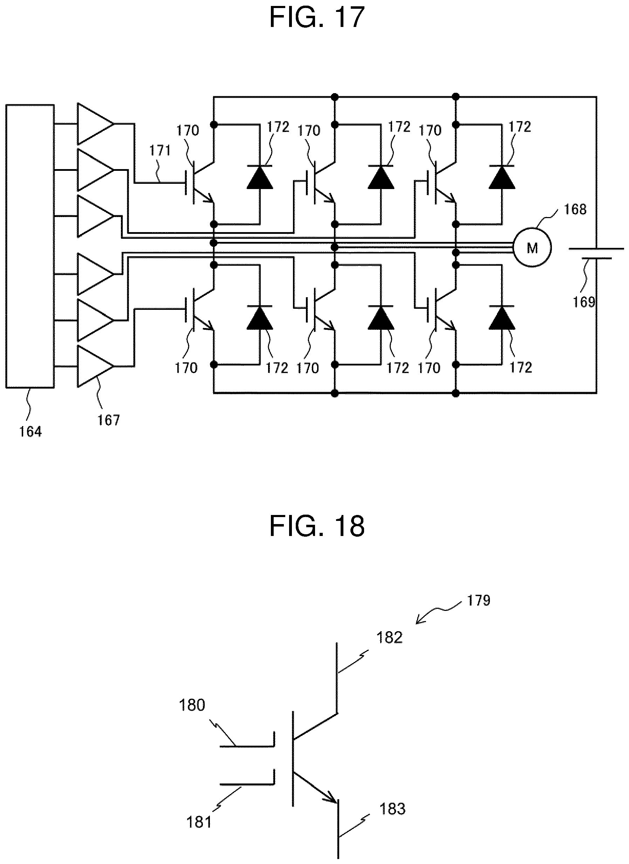

Fig. 17 is a view showing an example of the circuit configuration of a power converter constituting an inverter.

To an IGBT 170 having an insulated gate terminal 171, a diode 172 is connected in anti-parallel with the IGBT 170. The inverter has a configuration in which electric power is supplied from a voltage source 169, a voltage is applied to the insulated gate terminal 171 of the IGBT 170, turn-on and turn-off are repeated at high speed, and thus electric power to be supplied to an inductive load 168, which is connected, is controlled. It should be noted that an example the inductive load 168 is a motor (electric motor).

The IGBT 170 and the diode 172 produce a conduction loss at the time of conduction, and produce a switching loss at the time of switching. Therefore, in order to achieve a reduction in size and achieve high efficiency in the inverter, a conduction loss and a switching loss in the IGBT 170 and the diode 172 have to be reduced. Here, the switching loss is composed of a turn-on loss and a turn-off loss produced from the IGBT and a recovery loss produced from the diode at the time of turn on.

As techniques that reduce a conduction loss and a turn-off loss in the IGBT, techniques relating to double gate IGBTs are known as described in Patent Literature 1 or Patent Literature 2, the double gate IGBT having two gates that enables two ways of control independently.

Fig. 18 is a symbol diagram of a double gate IGBT 179 shown in Patent Literature 1.

The double gate IGBT 179 has two gate terminals 180 and 181to one collector terminal 182 and one emitter terminal 183, and the conduction and nonconduction of the IGBT is controlled by gate signals to be inputted to these two gate terminals.

Fig. 19 is a view showing the carrier density profile of the double gate IGBT.

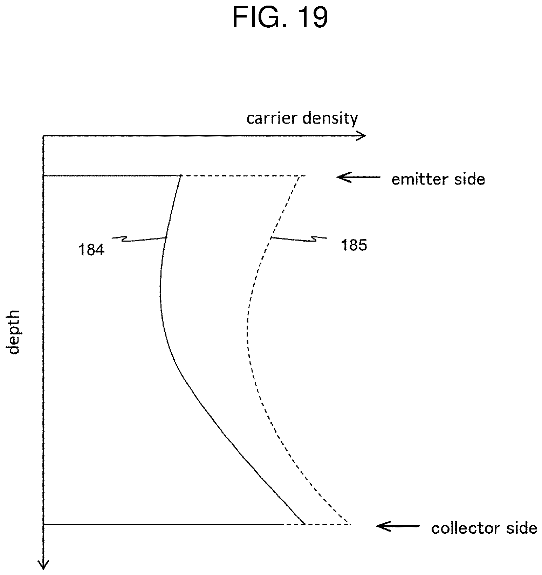

Fig. 19 shows a carrier density 185 (a broken line part) in the case in which an ON signal is inputted as a carrier density to two gates and a carrier density 184 (a solid line part) in the case in which an ON signal is inputted to one gate and an OFF signal is inputted to another gate.

At the carrier density 185 in the case in which the ON signal is inputted to the two gates, hole carrier injection from the emitter is promoted, the carrier density becomes high in the inside of the IGBT, and thus the ON voltage at the time of conduction of the IGBT can be reduced.

On the other hand, at the carrier density 184 in the case in which the ON signal is inputted to one gate and the OFF signal is inputted to one gate, hole carriers are discharged to the emitter, and thus the carrier density in the inside can be reduced.

In other words, the double gate IGBT enables the modulation of carrier density at the time of conduction of the IGBT using a newly added one gate and a gate voltage to be applied to that gate. With the use of the feature, the application of driving in which one gate signal is turned off beforehand immediately before turn-off switching enables a temporary decrease in the carrier density immediately before turn-off, and thus it is possible to derive a feature that is a low turn-off loss.

In the present invention, in the following, the above-described IGBT that can derive the effect of low losses by introducing these two gate signals at an appropriate timing is referred to as "a dual gate IGBT".

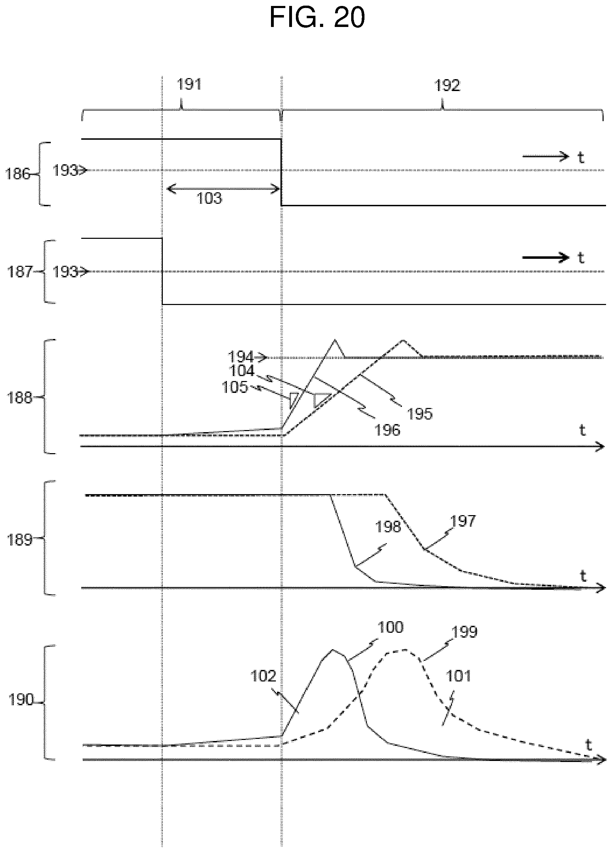

Fig. 20 is a view showing two gate signals 186 and 187, a voltage waveform 188, an electric current waveform 189, and an electric current-voltage product 190 at conduction time point 191 and a nonconduction time point 192 of a dual gate IGBT. It should be noted that in the voltage waveform, the electric current waveform, and the electric current-voltage product shown in Fig. 20, solid lines are the properties of the dual gate IGBT and broken lines are the properties of a single gate IGBT (a conventional IGBT having one gate).

In the dual gate IGBT, driving is applied in which an OFF signal is introduced beforehand to another carrier control gate 187 immediately before an input of an OFF signal that applies a voltage less than a threshold voltage from an ON-state in which a switching gate 186 is applied with a threshold voltage 198 or more. Turning off the carrier control gate 187 reduces the carrier density in the inside of the IGBT, and an ON voltage that is a collector-emitter voltage 195 is temporarily increased.

After that, the switching gate 186 is turned off, and the IGBT transitions from the conducting state to the nonconducting state. Therefore, the transition from the state in which the carrier density is low to the nonconducting state promotes depletion in the inside of the IGBT, and the collector-emitter voltage 195 is increased at high speed, compared with the conventional single gate IGBT. Moreover, carriers are also discharged at high speed, and thus the electric current 198 also transitions to zero ampere for a short time.

This configuration greatly reduces a turn-off loss 102 derived from the time integration of the electric current-voltage product to a loss 101 of the conventional single gate IGBT. Because of this property, the dual gate IGBT and its derivation method are techniques effective in achieving a reduction in an electric power loss in a power converter.

On the other hand, attention has to be paid to the highspeed switching waveform of the dual gate IGBT in regard to reliability. The voltage waveform 196 of the dual gate IGBT is increased steeply at the time of turning off. However, when a time variation dv_{CE}/dt 105 is increased too high, this causes problems on applications such as EMI (Electro Magnetic Interference) noise, induction problems sue to the power converter, and the insufficient insulation of the motor.

Since the dv_{CE}/dt 105 depends on the carrier density in the inside of the IGBT, the dv_{CE}/dt 105 changes depending on the electric current at the time of conduction of the IGBT or the temperature of the IGBT.

Therefore, in the dual gate IGBT that can achieve a reduction in a loss, the dv_{CE}/dt is managed at a certain level or below so as not to increase too high for maintaining reliability. For example, in the structure shown in Patent Literature 1, it has been difficult to suppress a high dv_{CE}/dt produced by switching at the time of changing the drive electric current of the dual gate IGBT or the temperature of the dual gate IGBT.

### Citation List

### Patent Literature

Patent Literature 1: Japanese Patent No. 4398719
Patent Literature 2: Japanese Unexamined Patent Application Publication No. 2016-162855

### Summary of Invention

### Technical Problem

The present invention enables maintaining a low electric power loss performance on conventional double gate IGBTs and enables obtaining a stable dv_{CE}/dt at the time of turn-on and turn-off switching even though temperatures change due to the conducting electric current of the dual gate IGBT or the heat generation in the dual gate IGBT. That is, the present invention is to provide a semiconductor circuit that is convertible between a low electric power loss and a high reliability, and a power converter to which the semiconductor circuit is applied.

### Solution to Problem

In order to solve the problem, the present invention is a semiconductor device comprising a dual gate IGBT having a first gate terminal and a second gate terminal. At time of transition of the dual gate IGBT from a nonconducting state to a conducting state, to the first gate terminal, a voltage at a threshold voltage or more is applied by a first predetermined time period beforehand from the second gate terminal. At time of transition of the dual gate IGBT from a conducting state to a nonconducting state, to the second gate terminal, a voltage less than the threshold voltage is applied by a beforehand by a second predetermined time period from the first gate terminal. The first predetermined time period and the second predetermined time period are variably controlled such that a time variation in a collector-emitter voltage of the dual gate IGBT is almost constant, the time variation being produced at the time of transition from a nonconducting state to a conducting state and at the time of transition from a conducting state to a nonconducting state.

### Advantageous Effects of Invention

According to the present invention, a low loss effect of the dual gate IGBT can be exerted under the conditions of high temperatures and high electric currents in which carrier density is the highest and an electric power loss becomes high at the time of switching of the IGBT, and the suppressing effect of dv_{CE}/dt of the dual gate IGBT can be exerted under the conditions of low temperatures and a small electric current in which carrier density is low and dv_{CE}/dt becomes high at the time of switching the IGBT.

That is, the performance of a low electric power loss and a stable dv_{CE}/dt at the time of switching can be achieved by controlling the rising time difference (t_{d_on}) and the falling time difference (t_{d_off}) between two gate signals. Thus, it is possible to provide a power converter that can maintain high reliability in regard to low power consumption, resistance to EMI noise, resistance to induction problems, and resistance to the insufficient insulation of a motor against conventional semiconductor devices.

Problems, configurations, and effects except ones described above will be apparent from the description of embodiments shown below.

### Brief Description of Drawings

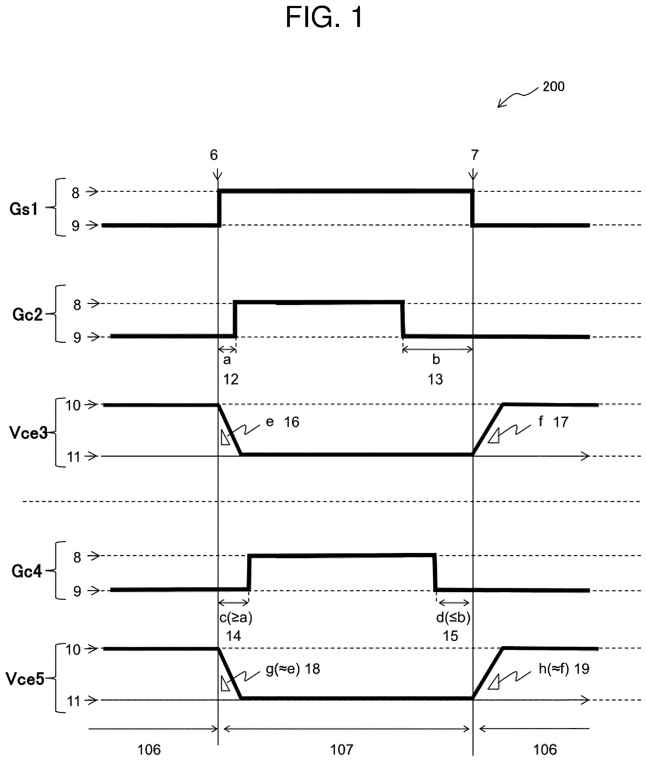

Fig. 1 is a view illustrating a driving method for a semiconductor device according to a first embodiment of the present invention.

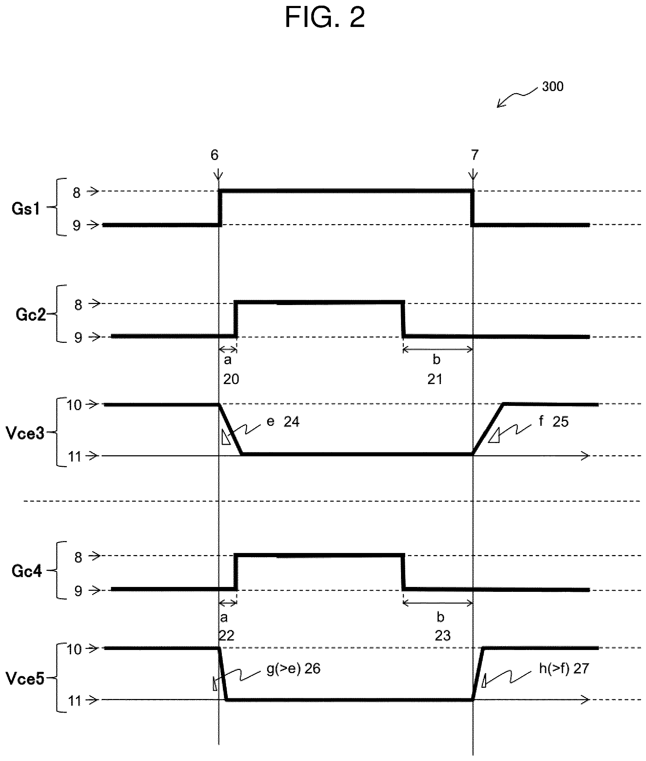

Fig. 2 is a view showing a driving method for a semiconductor device that is a comparative example.

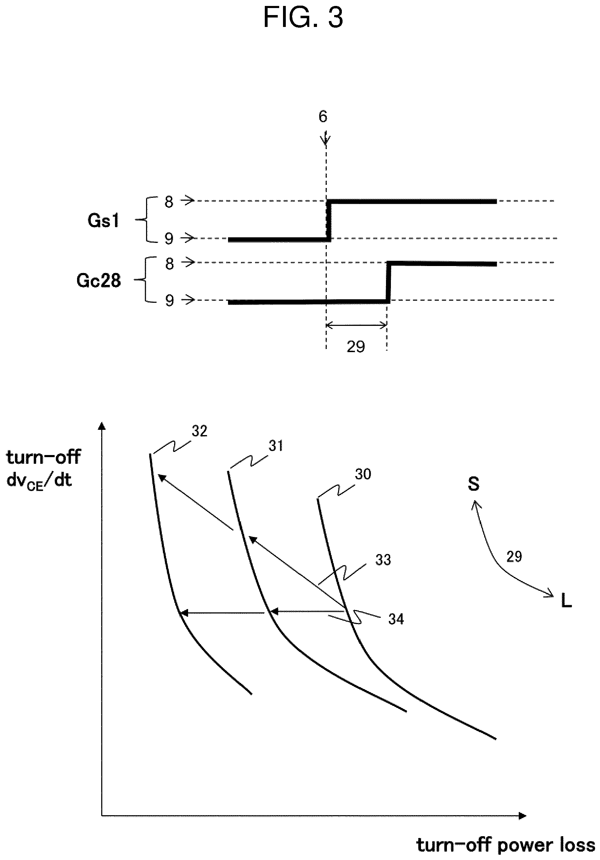

Fig. 3 is a view showing the correlation between a turn-on switching loss and a turn-on dv_{CE}/dt where a turn-on delay t_{d_on} is a parameter.

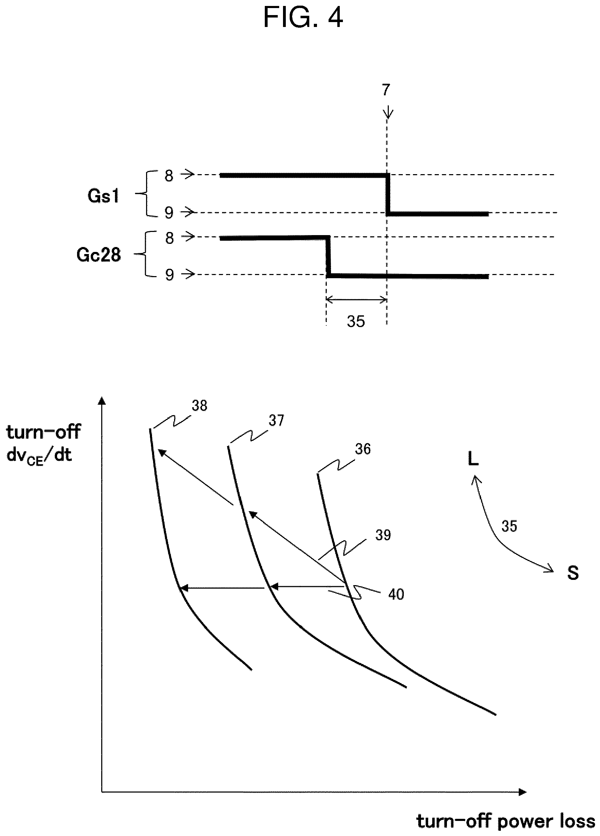

Fig. 4 is a view showing the correlation between a turn-off switching loss and a turn-off dv_{CE}/dt where a turn-off delay t_{d_off} is a parameter.

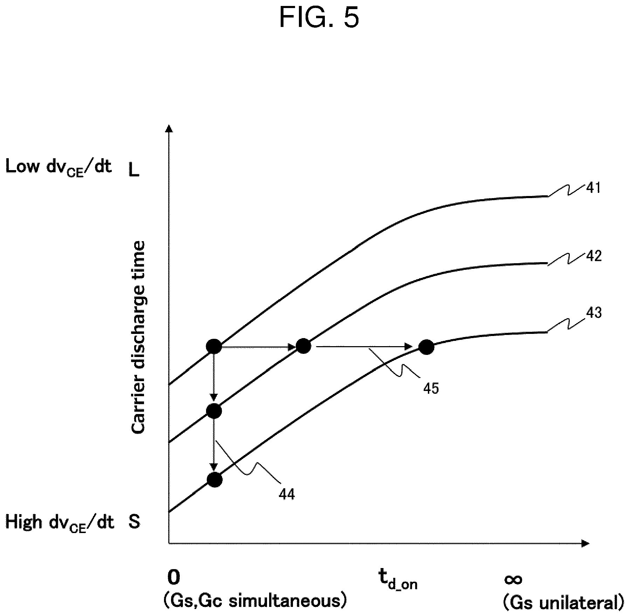

Fig. 5 is a view showing the relationship of carrier charge time in the inside of a dual gate IGBT to t_{d_on} at the time of turn-on switching.

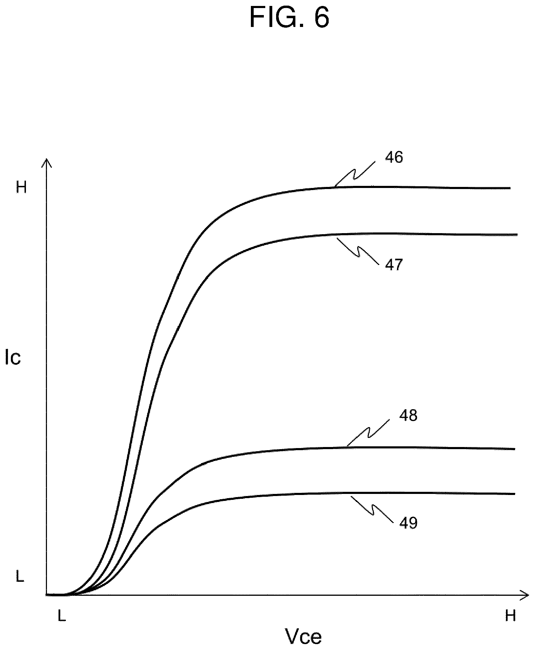

Fig. 6 is a view showing the forward V_{CE}-I_{C} property expressing the drive capability of the dual gate IGBT.

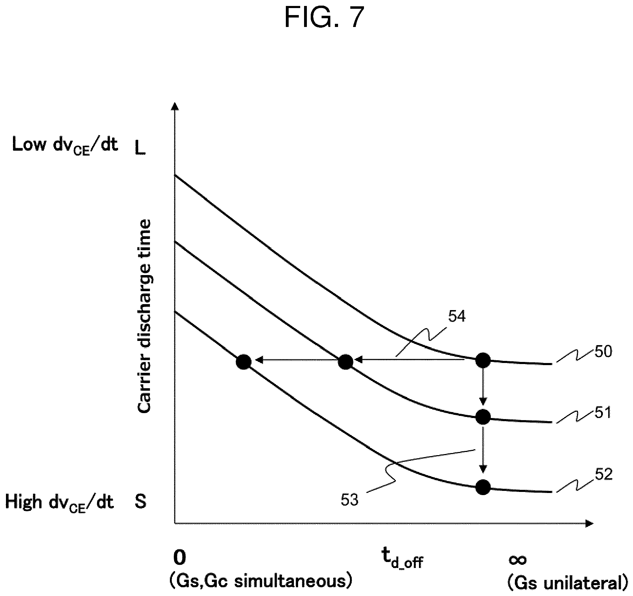

Fig. 7 is a view showing the relationship of carrier discharge time in the inside of the dual gate IGBT to t_{d_off} at the time of turn-off switching.

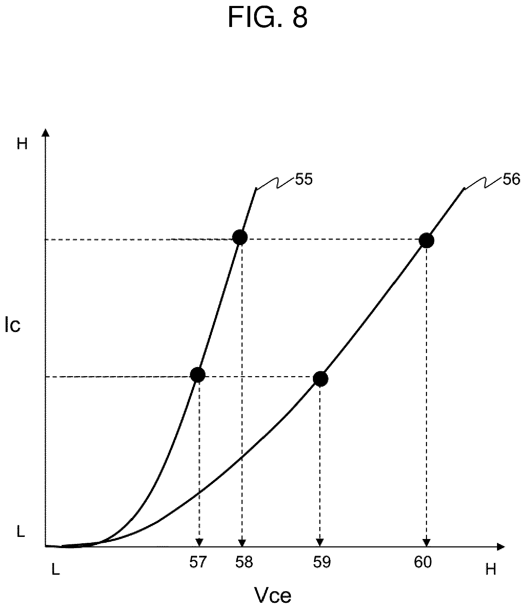

Fig. 8 is a view showing the forward properties of a dual gate IGBT according to a second embodiment of the present invention.

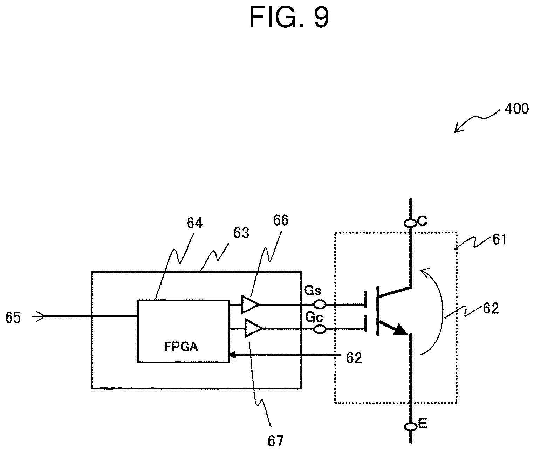

Fig. 9 is a block diagram of a second embodiment of the present invention composed of a drive circuit that generates two signals capable of variably controlling t_{d_on} and t_{d_off} and a dual gate IGBT.

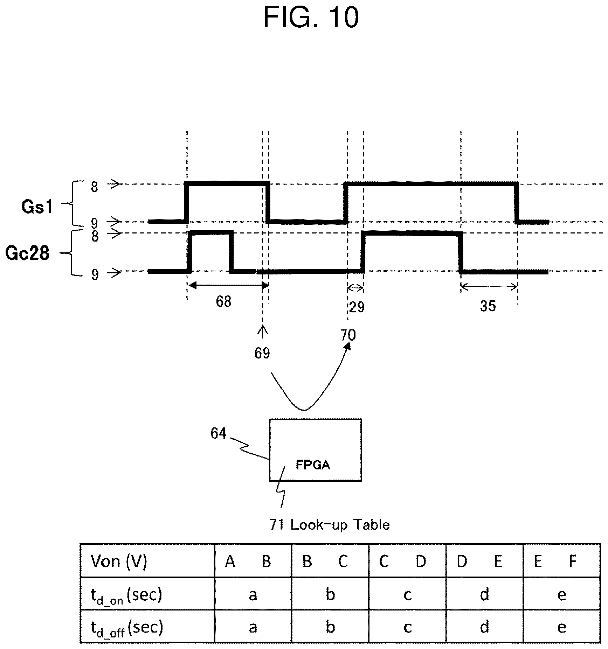

Fig. 10 is a view showing the timings of acquiring the temperature of a dual gate IGBT and information about an electric current, methods of deriving an optimum t_{d_on} and an optimum t_{d_off}, and a look-up table written on an FPGA.

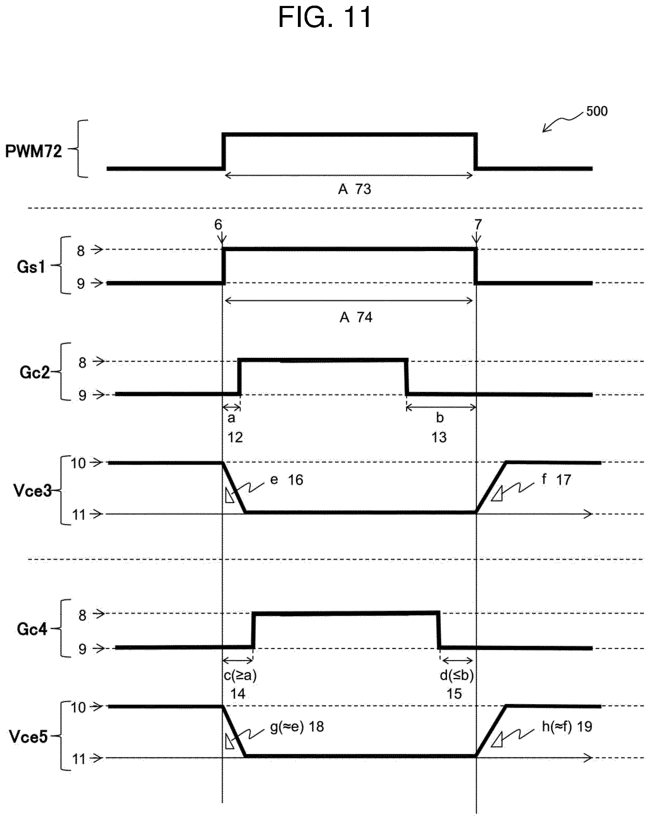

Fig. 11 is a view showing a driving method for a semiconductor device according to a third embodiment of the present invention.

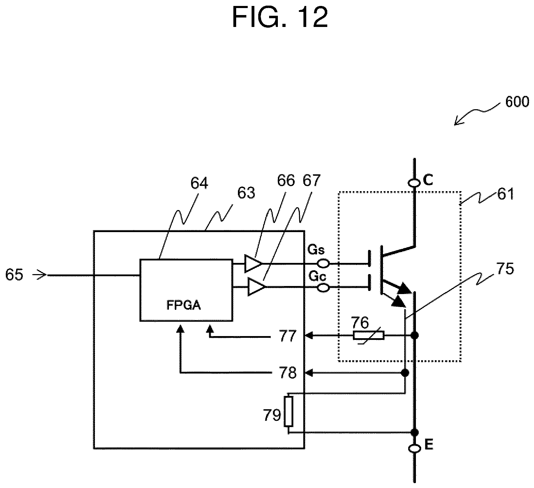

Fig. 12 is a diagram showing a state sensing method and a configuration of a semiconductor device according to a fourth embodiment of the present invention.

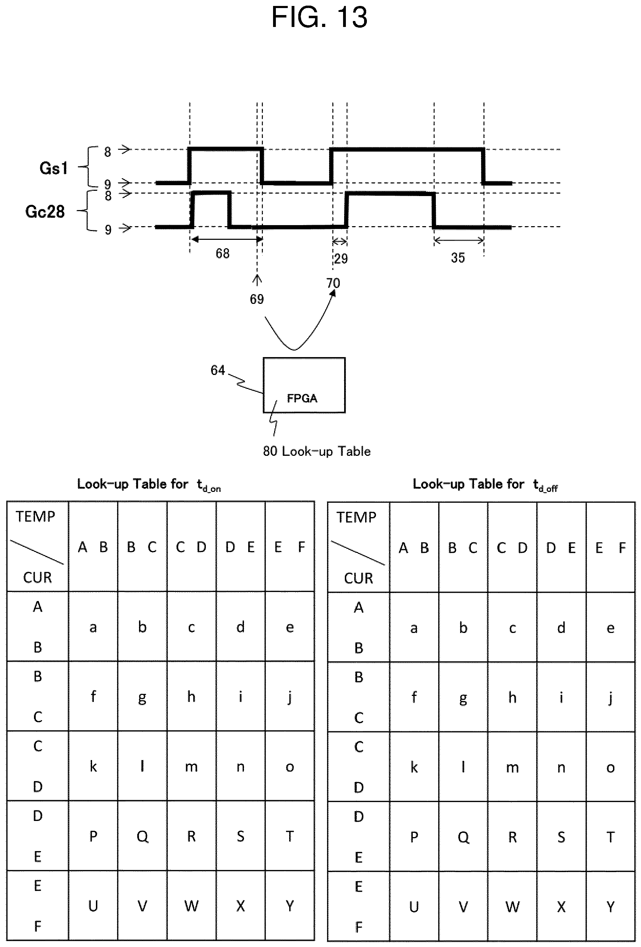

Fig. 13 is a view showing the timings of acquiring the temperature of a dual gate IGBT and information about an electric current, methods of deriving an optimum t_{d_on} and an optimum t_{d_off}, and a look-up table written on an FPGA in the fourth embodiment.

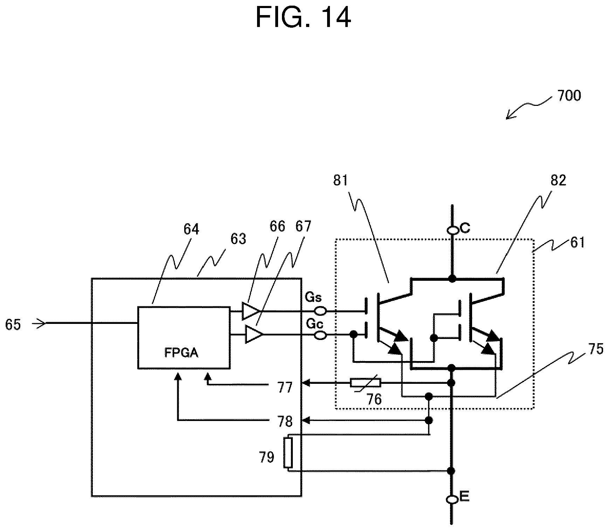

Fig. 14 is a diagram showing a state sensing method and a configuration of a semiconductor device according to a fifth embodiment of the present invention.

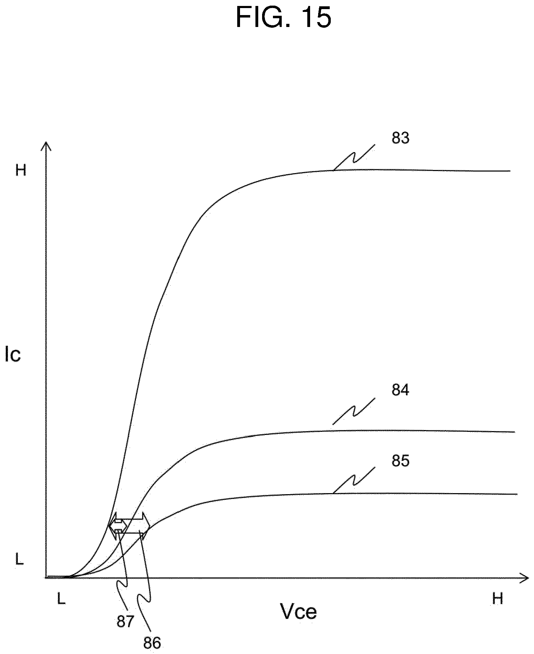

Fig. 15 is a view showing the forward V_{CE}-I_{C} property expressing the drive capability of the dual gate IGBT according to the fifth embodiment.

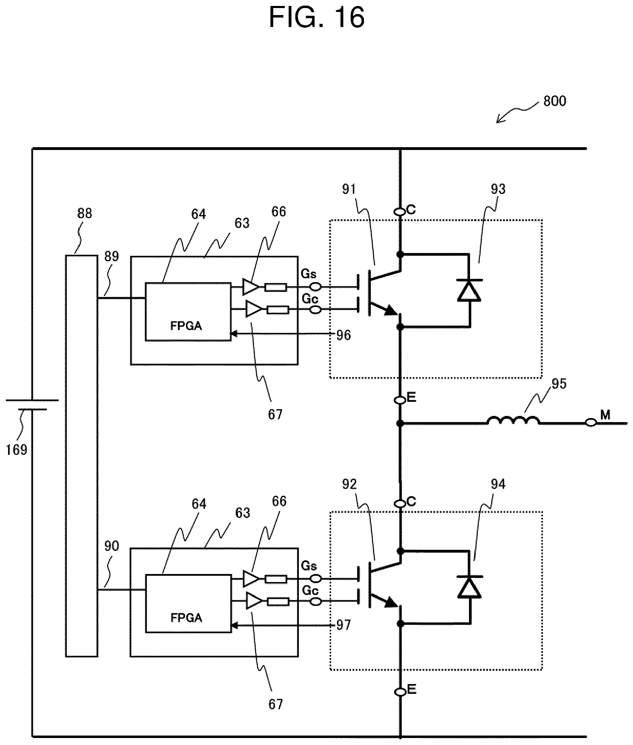

Fig. 16 is a view showing an example configuration of a power converter according to a sixth embodiment of the present invention.
Fig. 17 is a view showing an example of the circuit configuration of a power converter constituting an inverter.
Fig. 18 is a symbol diagram of a double gate IGBT.
Fig. 19 is a view showing the carrier density profile of a double gate IGBT.
Fig. 20 is a view showing two gate signals, a voltage waveform, an electric current waveform, and the time transition of an electric current-voltage product using these waveforms at the time of conduction and nonconduction of a dual gate IGBT.

### Description of Embodiments

In the following, as embodiments for carrying out the present invention, first to sixth embodiments of the present invention will be described with reference to the drawings. It should be noted that in the drawings, conductive lines conducting gate signals are simply depicted as one line for a gate terminal. However, reference conductive lines with reference to an emitter potential are actually present, and a voltage is inputted with respect to the reference potential. However, in the drawings, the reference conductive lines conducting electricity to the emitter of a dual gate IGBT are omitted.

### First Embodiment

A driving method 200 in an insulated gate (gate controlled) semiconductor device according to a first embodiment of the present invention will be described.

Fig. 1 is a view showing the waveforms of drive signals and the waveforms of collector-emitter voltages (V_{CE}) of a dual gate IGBT according to the first embodiment for describing the driving method 200.

The semiconductor device used as the first embodiment is formed of a dual gate IGBT having two gates that enables two ways of control independently and a driving method for the dual gate IGBT. The dual gate IGBT is composed of two insulated gate terminals, one emitter terminal, and one collector terminal. As the operation form, the dual gate IGBT is turned into a conducting state by a gate-emitter voltage at a threshold voltage or more to be applied to at least one gate terminal (in the following, referred to as "a gate voltage"), and the dual gate IGBT is turned into a nonconducting state by a gate voltage less than a threshold voltage to be applied to two gate terminals. That is, the dual gate IGBT is an IGBT that enables control conduction and nonconduction by gate voltages to be applied to the two gate terminals.

Here, the gate terminal that enables control over the timings of conduction and nonconduction is defined as "a switching gate (Gs)", and anther gate terminal is defined as "a carrier control gate (Gc)" as a terminal that enables control over the carrier density in the inside of the dual gate IGBT.

In a nonconducting period 106, since signals to a Gs gate 1 and a Gc gate 2 are both at a voltage less than the threshold voltage, no carrier is injected, and a high voltage 10 is applied to V_{CE}3.

Subsequently, at turn-on timing 6, a voltage at the threshold voltage or more (in the following, referred to as "a turn-ON signal") is applied to the Gs gate 1, carriers are injected, and the IGBT transitions to s conducting period 107.

Here, a time difference a(t_{d_on}) 12 is provided to the turn-ON signals for the Gs gate 1 and the Gc gate 2, carrier injection time is prolonged, compared with the case in which turn-ON signals are simultaneously inputted without providing this time difference. Thus, a transition period from conduction to nonconduction can be provided long. That is, a time variation dv_{CE}/dt 16 for V_{CE}3 can be decreased.

After the Gc gate 2 is turned on, the electric conductivity modulation of the IGBT is promoted, and a low conduction loss performance of the dual gate IGBT is achieved.

Subsequently, in a period 13 immediately before turn-off, the signal for the Gc gate 2 is decreased less than the threshold voltage before the signal for the Gs gate 1. This discharges carriers in the inside of the IGBT to suppress conductivity modulation, and thus the state transitions to the state in which the carrier density is reduced.

After that, at turn-off timing 7, upon applying a voltage less than the threshold voltage (in the following, referred to as "a turn-OFF signal") to the Gs gate 1, depletion proceeds in the inside of the IGBT by a power supply voltage applied across the collector and the emitter, and a collector-emitter voltage 3 is increased. Carriers are discharged, the collector electric current is interrupted, and the period transitions to the nonconducting period 106.

Here, a time difference b(t_{d_off}) 13 is provided to the turn-OFF signals for the Gs gate 1 and the Gc gate 2, and thus carrier discharge time is shortened, compared with the case in which the turn-OFF signals are simultaneously inputted without providing the time difference. Thus, dv_{CE}/dt 17 is increased, and the interruption time of the collector electric current is shortened. Therefore, a turn-off loss can be decreased.

The first embodiment has a feature in which t_{d_on} and t_{d_off} are variably controlled depending on the temperature and the conducting electric current of the dual gate IGBT. For t_{d_on}, a relatively large value 14 is provided as the temperature of the dual gate IGBT is low and the conducting electric current is low. For t_{d_off}, a relatively small value 15 is provided as the temperature of the dual gate IGBT is low and the conducting electric current is low.

As described above, t_{d_on} 12 and t_{d_on} 14 and t_{d_off} 13 and t_{d_off} 15 are changed for driving corresponding to the state of the dual gate IGBT, and thus dv_{CE}/dt 16 and dv_{CE}/dt 18 at the time of turn-on and dv_{CE}/dt 17 and dv_{CE}/dt 19 at the time of turn-off can be made nearly constant.

Therefore, it is possible to derive a low loss performance the dual gate IGBT, and it is possible to maintain reliability to EMI noise, induction problems, and motor insulation.

Fig. 2 is a view showing a driving method 300 as a comparative example with respect to the driving method 200 according to the first embodiment in the case in which a dual gate IGBT is driven as t_{d_on} 20 and t_{d_on} 22 and t_{d_off} 21 and t_{d_off} 23 are fixed values.

In the case in which t_{d_on} 20 and t_{d_on} 22 and t_{d_off} 21 and t_{d_off} 23 are fixed values, dv_{CE}/dt is increased in dv_{CE}/dt 24 and dv_{CE}/dt 26 at the time of turn-on switching under the conditions under which the temperature of the dual gate IGBT is low and the conducting electric current is low. This results from shortening time in which carriers are injected to stabilize carrier density.

Also, dv_{CE}/dt is increased in dv_{CE}/dt 25 and dv_{CE}/dt 27 at the time of turn-off switching under the conditions under which the temperature of the dual gate IGBT is low and the conducting electric current is low. This results from shortening time in which carriers are discharged.

As described above, in the driving method 300 shown in the comparative example, it is possible to derive a low loss performance the dual gate IGBT on one hand, and concerns remain about reliability relating to EMI noise, induction problems, and motor insulation when the temperature of the dual gate IGBT or the current carrying conditions change.

Next, in regard to the tradeoff between the switching loss and dv_{CE/}dt, the effect of the first embodiment will be described using the drawings.

Fig. 3 is a view showing the relationship between the turn-on switching loss and the turn-on dv_{CE}/dt where t_{d_on} 29 is a parameter. It should be noted that as the driving conditions, three conditions are shown, a high-temperature-high-electric-current driving condition 30, a high-temperature-low-electric-current driving condition 31, and a low-temperature-low-electric-current driving condition 32.

With an increase in t_{d_on} 29, a tendency is shown in which dv_{CE}/dt is reduced and the turn-on switching loss is increased. In regard to the loss, a tendency is shown in which the loss is increased under the high-temperature-high-electric-current driving condition. On the other hand, in regard to dv_{CE/}dt, a tendency is shown in which dv_{CE}/dt is decreased under the high-temperature-high-electric-current driving condition.

Here, in regard to dv_{CE/}dt, in the case in which an upper limit specification value is provided from the viewpoint of reliability, a driving method 34 is provided in which t_{d_on} 29 is changed suitable for the temperature and the drive electric current, and thus it is possible to satisfy the specification of dv_{CE}/dt and it is possible to most decrease the turn-on switching loss in the dual gate IGBT. It should be noted that for comparison, a driving method 33 is shown in the case in which the same time is set with no change in t_{d_on} 29.

Fig. 4 is a view showing the relationship between the turn-off switching loss and the turn-off dv_{CE}/dt where t_{d_off} 35 is a parameter. It should be noted that as the driving conditions, three conditions are shown, a high-temperature-high-electric-current driving condition 36, a high-temperature-low-electric-current driving condition 37, and a low-temperature-low-electric-current driving condition 38.

With an increase in t_{d_off} 35, a tendency is shown in which dv_{CE}/dt is increased and the turn-off switching loss is reduced. In regard to the loss, a tendency is shown in which the loss is increased under the high-temperature-high-electric-current driving condition. On the other hand, in regard to dv_{CE/}dt, a tendency is shown in which dv_{CE}/dt is decreased under the high-temperature-high-electric-current driving condition.

Here, in regard to dv_{CE/}dt, in the case in which an upper limit specification value is provided from the viewpoint of reliability, a driving method 40 is provided in which t_{d_off} 35 is changed suitable for the temperature and the drive electric current, and thus it is possible to satisfy the specification of dv_{CE/}dt, and it is possible to most decrease the turn-off switching loss in the dual gate IGBT. It should be noted that for comparison, a driving method 39 is shown in the case in which the same time is set with no change in t_{d_off} 35.

Next, the reason why the effect of the first embodiment is obtained will be described.

Fig. 5 is a view showing the relationship of carrier charge time in the inside of the dual gate IGBT to t_{d_on} at the time of turn-on switching. Here, the term "carrier charge time" is time in which conductivity modulation occurs in the drift region due to electron carriers injected from the emitter for stabilizing carrier density. It should be noted that as the driving conditions, three conditions are shown, high-temperature-high-electric-current driving 41, high-temperature-low-electric-current driving 42, low-temperature-low-electric-current driving 43.

With an increase in t_{d_on}, a tendency is shown in which the carrier charge time is prolonged. This is because a period transitioning to the state of a high electric current drive capability is prolonged by injecting carriers to the Gs gate alone in the two gates, which are the Gs gate and the Gc gate, i.e., the state of a low electric current drive capability is long and the Gc gate that is another gate is turned on.

Fig. 6 is a view showing V_{CE}-I_{C} waveforms 46 and 47 that are drive capabilities when the two gates, which are the Gs gate and the Gc gate, are turned on, and V_{CE}-I_{C} waveforms 48 and 49 that are drive capabilities when the Gs gate alone is turned on.

In the case in which the Gs gate and the Gc gate have almost equal areas, the drive capabilities 48 and 49 when the Gs gate alone is turned on can conduct control with suppression nearly a half of the drive capabilities 46 and 47 when the two gates, which are the Gs gate and the Gc gate, are turned on.

With a prolonged carrier charge time, time in which V_{CE} changes is prolonged from the initial state in which depletion is achieved and a high voltage is applied to the state in which carriers are charged to reach the ON voltage that is a voltage drop in the forward direction, and thus dv_{CE}/dt is decreased.

Under the low-temperature-low-electric current driving conditions 46 and 48, transconductance becomes high and carrier density to charge drops, and thus the carrier charge time is shortened, i.e., dv_{CE}/dt is increased.

As shown in Fig. 5, from this relationship, a driving method 45 is provided in which t_{d_on} is set to a relatively large value as the temperature of the dual gate IGBT is low and the amount of a conducting electric current is small, and thus the turn-on switching at a stable dv_{CE}/dt is enabled. It should be noted that for comparison, a driving method 44 is shown in the case in which the same time is set with no change in t_{d_on} 29.

Fig. 7 is a view showing the relationship of carrier discharge time in the inside of the dual gate IGBT to t_{d_off} at the time of turn-off switching. Here, the term "carrier discharge time" is time to deplete the drift region by discharging hole carriers to the emitter from the initial state in which carrier density is high in the drift region due to electric conductivity modulation. It should be noted that as the driving conditions, three conditions are shown, a high-temperature-high-electric-current driving condition 50, a high-temperature-low-electric-current driving condition 51, and a low-temperature-low-electric-current driving condition 52.

With an increase in t_{d_off}, a tendency is shown in which the carrier discharge time is shortened. This is because the period in which the Gc gate is turned off beforehand is provided, carriers are discharged beforehand prior to turn-off, and carrier density is decreased.

With the shortened carrier discharge time, time in which V_{CE} changes is shortened from the initial state in which carriers are charged and the ON voltage that is a voltage drop in the forward direction to the state in which depletion is achieved and a high voltage is applied, and thus dv_{CE}/dt is increased.

Under the low-temperature-low-electric-current driving condition 52, the carrier lifetime is short and the initial carrier density is low, and thus carrier discharge time is short, i.e., dv_{CE}/dt is increased.

With the relationship described above, by a driving method 54 in which t_{d_off} is set to a relatively small value as the temperature of the dual gate IGBT is low and the amount of a conducting electric current is small, the turn-off switching at a stable dv_{CE}/dt is enabled. It should be noted that for comparison, a driving method 53 is shown in the case in which the same time is set with no change in t_{d_off} 35.

As described above, the first embodiment of the present invention shows that the dual gate IGBT enables switching at stable dv_{CE}/dt to the temperature or the current carrying conditions in a low loss performance.

### Second Embodiment

A state sensing method 400 in an insulated gate (gate controlled) semiconductor device according to a second embodiment of the present invention they will be described.

Fig. 8 is a view showing the correlation between the collector electric current and the collector-emitter voltage of a dual gate IGBT according to the present embodiment, i.e., the forward properties.

Fig. 8 shows the properties at a high temperature 56 and at an ambient temperature 55, and a voltage drop produced when the collector electric current is carried (in the following, referred to as "the ON voltage", and in the drawing, referred to as "Von") becomes large (a change from 57 to 60) as the electric current and the temperature are high. This is because the carrier density necessary to carry the electric current as the electric current becomes high and this increases a voltage necessary for injection, whereas the carrier lifetime is long and the carrier density is high as temperature becomes high and this increases a voltage necessary for injection similarly. With the properties, the ON voltage of the dual gate IGBT is monitored, and thus the temperature of the dual gate IGBT or the size of the conducting electric current can be sensed.

Fig. 9 is a view showing the configuration for the sensing method 400 according to the present embodiment. The configuration is composed of a drive circuit 63 that generates two signals capable of variably controlling t_{d_on} and t_{d_off} and a dual gate IGBT 61.

The drive circuit 63 senses the collector-emitter potential difference of the dual gate IGBT 61, i.e., an ON voltage 62. Upon receiving information about the ON voltage, a programmable integrated circuit, an FPGA (Field-Programmable-Gate-Array) 64, for example, provided in the inside of the drive circuit 63 derives two timing signals provided with appropriate t_{d_on} and t_{d_off} to the ON voltage 62 of the dual gate IGBT.

In the inside of the drive circuit 63, the timing signals are converted into voltages by buffer circuits 66 and 67, and are given as gate signals to the Gs gate terminal and the Gc gate terminal of the dual gate IGBT 61.

With this configuration, the dual gate IGBT 61 can be driven using appropriate t_{d_on} and t_{d_off} suitable for the temperature and the conducting electric current of the dual gate IGBT 61, and switching achieving both a low loss and a stable dv_{CE}/dt can be implemented.

Fig. 10 is a view showing the timings of acquiring the temperature of the dual gate IGBT and information about the electric current and a method for deriving the optimum t_{d_on} 29 and the optimum t_{d_off} 35 in the present embodiment.

t_{d_on} 29 and t_{d_off} 35 can be set by reading the ON voltage in a previous conducting pulse period 68 in the dual gate IGBT (a time point 69) and loading a value suitable for the ON voltage by the FPGA 64.

Here, to the FPGA 64, the ON voltage corresponding to the values of the optimum t_{d_on} 29 and the optimum t_{d_off} 35 are recorded in advance using a program. As an example, the values are recorded in a form of correspondence table (look-up table) 71 shown in the lower part in Fig. 10. Here, the look-up table 71 is a correspondence table in which the output values of t_{d_on} 29 and t_{d_off} 35 are determined in a single meaning to the input value of the sensed ON voltage such that t_{d_on} 29 is "a" and t_{d_off} 35 is "a" when the ON voltage is A or more and less than B, for example.

In the dual gate IGBT, the electric current is carried for switching in the previous conducting pulse period 68, and thus heat is generated due to an electric power loss, and the temperature is increased. Since this temperature is the temperature of the dual gate IGBT in the subsequent turn-on switching, sensing the ON voltage in the previous conducting pulse period is valid.

Since the drive electric current of the dual gate IGBT driving a motor load takes a continuous value, an electric current immediately before the previous conducting pulse period of the dual gate IGBT is finished is the subsequent drive electric current of the dual gate IGBT at the time of turn-on switching. Therefore, also form the viewpoint of the electric current conditions, sensing the ON voltage in the previous conducting pulse period 68 is valid.

As described above, the second embodiment of the present invention shows that the dual gate IGBT enables switching at a stable dv_{CE}/dt to the temperature or the current carrying conditions in a low loss performance.

### Third Embodiment

A driving method 500 in an insulated gate (gate controlled) semiconductor device according to a third embodiment of the present invention will be described.

Fig. 11 is a view showing the waveforms of drive signals and the waveforms of collector-emitter voltages (V_{CE}) of a dual gate IGBT according to the present embodiment.

The present embodiment relates to a driving method for a semiconductor device using a dual gate IGBT, as an IGBT, having two gates that enables two ways of control independently.

The drive signal of the dual gate IGBT is generated from a command signal 72 of a power converter. In the case in which an alternating current wave for driving a motor is outputted from an inverter formed of a dual gate IGBT, the command signal 72 is a PWM (Pulse Width Modulation) signal with conducting pulse duration modulated.

Fig. 11 shows a PWM command signal 72, a Gs gate signal 1, and Gc signals 2 and 4. The PWM command signal 72 has its conducting pulse duration controlled such that the alternating current wave to be outputted is a high-quality waveform having small electric current ripples. Controlling conduction and nonconduction by turning on and off the dual gate IGBT corresponding to this command signal is important to keep a high-quality inverter output waveform.

Therefore, a conducting pulse duration 74 of the Gs gate signal 1 that determines the timings of conduction and nonconduction is necessary to be equal to a conducting pulse duration 73 of the PWM command signal. Moreover, in order to derive a low loss performance of the dual gate IGBT describe above, periods for t_{d_on} 12 and t_{d_off} 13 have to be provided, and this can be implemented by shortening the conducting pulse duration of the Gc gate signal 2.

In order to derive switching at a stable dv_{CE}/dt to changes in the temperature of the dual gate IGBT or the conducting electric current of the dual gate IGBT described above, periods of t_{d_on} 12 and t_{d_on} 14 and t_{d_off} 13 and t_{d_off} 15 have to be adjusted suitable for the temperature and the conducting electric current, and this can be implemented by adjusting the conducting pulse durations of the Gc gate signals 2 and 4.

That is, upon receiving a PWM command signal 65, the drive circuit 63 shown in Fig. 9 outputs the Gs gate signal having the same conducting pulse duration, and outputs the Gc gate signal having the conducting pulse duration variably control such that the optimum t_{d_on} and the optimum t_{d_off} are provided suitable for the temperature of the dual gate IGBT and the conducting electric current of the dual gate IGBT. Thus, in addition to a low loss and a switching waveform at a stable dv_{CE/}dt, it is possible to derive a high-quality alternating output wave.

As described above, the third embodiment the present invention shows that the dual gate IGBT enables switching at a stable dv_{CE}/dt to the temperature or the current carrying conditions in a low loss performance and an output of a high-quality alternating current wave having small electric current ripples.

### Fourth Embodiment

A state sensing method 600 in an insulated gate (gate controlled) semiconductor device according to a fourth embodiment of the present invention will be described.

Fig. 12 is a view of the configuration of the sensing method 600 of the present embodiment. The configuration is composed of a drive circuit 63 that generates two signals capable of variably controlling t_{d_on} and t_{d_off} and a dual gate IGBT 61.

On the emitter side of the dual gate IGBT 61, an emitter terminal, an emitter electric current sensing terminal 75, and a thermistor 76 are connected. The thermistor 76 is connected to the emitter terminal, and enables detection of temperatures. The drive circuit 63 senses the temperature of the dual gate IGBT 61 through the thermistor 76, and senses an electric current through a voltage applied to a resistor 79 provided in the drive circuit 63 and connected to the emitter electric current sensing terminal 75 and the emitter terminal of the dual gate IGBT.

Upon receiving the sensing information of the temperature 77 and the electric current 78 described above, a programmable integrated circuit provided in the inside of the drive circuit 63, an FPGA 64, for example, derives two timing signals provided with appropriate t_{d_on} and t_{d_off} to the temperature of the dual gate IGBT and the electric current.

In the inside of the drive circuit 63, the timing signals are converted into voltages by buffer circuits 66 and 67, and the timing signals are given as gate signals to the Gs gate terminal and the Gc gate terminal of the dual gate IGBT. With the configuration described above, the dual gate IGBT 61 can be driven at appropriate t_{d_on} and t_{d_off} suitable for the temperature and the conducting electric current of the dual gate IGBT 61, and switching achieving both a low loss and a stable dv_{CE}/dt can be implemented.

Fig. 13 is a view showing the timings of acquiring the temperature of the dual gate IGBT and a method for deriving information about the electric current 69 and the optimum t_{d_on} 29 and the optimum t_{d_off} 35 in the present embodiment.

t_{d_on} 29 and t_{d_off} 35 can be set by reading the temperature and the electric current in the previous conducting pulse period 68 of the dual gate IGBT (a time point 69) and loading a value suitable for the ON voltage by the FPGA 64. Here, to the FPGA 64, the values of the optimum t_{d_on} 29 and the optimum t_{d_off} 35 suitable for the temperature of the dual gate IGBT and the electric current are recorded in advance using a program. As an example, the values are recorded on a correspondence table (look-up table) 80 shown in the lower part in Fig. 13. The look-up table 80 is a two-dimensional correspondence table corresponding to t_{d_on} and t_{d_off} for the temperature and the electric current. For example, the look-up table 80 is correspondence table in which the output values of t_{d_on} 29 and t_{d_off} 35 are determined in a single meaning to the input values of the temperature and the electric current, which are sensed, when the temperature of the dual gate IGBT is A or more and less than B and the electric current is A or more and less than B such that t_{d_on} 29 is "a" (on the left side of the table) and t_{d_off} 35 is "a" (on the right side of the table) .

Also in the state sensing method 600 according to the present embodiment, the operation and effect similar to the second embodiment above (the state sensing method 400 shown in Fig. 9) can be exerted, and the present embodiment can more directly sense the temperature and the electric current, compared with a method indirectly sensing the temperature and the electric current by the ON voltage of the dual gate IGBT like the state sensing method 400 of the second embodiment, and thus the state sensing method 600 can achieve more highly accurately sensing.

As described above, the fourth embodiment of the present invention shows that the dual gate IGBT enables switching at a stable dv_{CE}/dt to the temperature or the current carrying conditions in a low loss performance.

### Fifth Embodiment

A state sensing method 700 in an insulated gate (gate controlled) semiconductor device according to the fifth embodiment of the present invention will be described.

Fig. 14 is a view of the configuration of then sensing method 700 of the present embodiment. The configuration is composed of a drive circuit 63 that generates two signals capable of variably controlling t_{d_on} and t_{d_off} and a dual gate IGBT 61.

The dual gate IGBT 61 has a configuration in which the dual gate IGBT 61 is solid into two devices and connected in parallel with each other. To the individual devices, an emitter terminal and an emitter electric current sensing terminal 75 are provided. Here, two gates of one device 82 in the dual gate IGBT split into two components are both connected to a Gc gate. That is, the ratio of the number of Gs gates to the number of the Gc gates of the dual gate IGBT 61 is 1 : 3. Anther device 82 connected to together to the Gc gate may be a single gate IGBT, not necessarily a dual gate IGBT.

Two emitter terminals are connected to a thermistor 76 that enables temperature sensing. The drive circuit 63 senses the temperature of the dual gate IGBT 61 through the thermistor 76, and senses an electric current through a voltage applied to a resistor 79 provided in the drive circuit 63 and connected to the emitter electric current sensing terminal 75 and the emitter terminal of the dual gate IGBT 61.

Upon receiving the sensing information of the temperature 77 and the electric current 78 described above, a programmable integrated circuit provided in the inside of the drive circuit 63, an FPGA 64, for example, derives two timing signals provided with appropriate t_{d_on} and t_{d_off} to the temperature of the dual gate IGBT 61 and the electric current.

In the inside of the drive circuit 63, the timing signals are converted into voltages by buffer circuits 66 and 67, and signals are inputted as gate signals to the Gs gate and the Gc gate terminal of the dual gate IGBT.

Fig. 15 shows the forward current properties of the dual gate IGBT, specifically showing a drive performance 83 when the Gs gate and the Gc gate are both turned on and drive performances 84 and 85 when the Gs gate is turned on and the Gc gate is turned off. Here, in regard to the latter drive performances 84 and 85, the performance in the case in which the ratio of the numbers of the Gs gate and the Gc gate of the present embodiment is 1 : 3 is 85, and the performance in the case in which the ratio of the numbers shown in the first to the fourth embodiments above is 1 : 1 is 84.

An increase in the ratio of the numbers decreases the drive performance when the Gs gate is turned on and the Gc gate is turned off. That is, the difference in the drive performance 83 when the Gs gate and the Gc gate are both turned on is increased. This expresses that the carrier controllability of the dual gate IGBT due to the bias of the Gc gate is improved.

Therefore, the configuration of the dual gate IGBT shown in the present embodiment can improve both the adjustment amount of dv_{CE}/dt at the time of turn-on switching by t_{d_on} and the adjustment amount of dv_{CE}/dt at the time of turn-off switching by t_{d_off}. Thus, control stability to variations in t_{d_on} and t_{d_off} can be improved. That is, the stability of dv_{CE}/dt at the time of switching by the optimum control of t_{d_on} and t_{d_off} suitable for the temperature of the dual gate IGBT and the electric current can be improved.

As described above, the fifth embodiment of the present invention shows that the dual gate IGBT enables switching at a stable dv_{CE}/dt to the temperature or the current carrying conditions in a low loss performance.

### Sixth Embodiment

Fig. 16 is a view showing an example configuration of a power converter according to a sixth embodiment of the present invention.

A power converter 800 of the present embodiment is an inverter that drives an inductive load 95, which is mainly a motor, and converts a direct current voltage (electric power) 169 into an alternating voltage (electric power), and supplied the alternating voltage (electric power) to the inductive load 95.

Fig. 16 shows a circuit composed of dual gate IGBTs 91 and 92 for upper and lower arms for one phase, and diodes 93 and 94 in anti-parallel connection. However, the present embodiment is applied in the case in which a power converter is composed of dual gate IGBTs for upper and lower arms for three phases, the U-phase, the V-phase, and the W-phase, and drives a motor, which is an inductive load.

In order to obtain the alternating waveform to be outputted, an instruction unit 88 inputs PWM command signals 89 and 90 having their conducting pulse durations to a drive circuit 63. Upon receiving the PWM command signal, an FPGA 64 provided in the inside of a drive circuit 63 generates the Gs gate signal and the Gc gate signal having t_{d_on} and t_{d_off} adjusted optimally suitable for the electric current and the temperature of the dual gate IGBTs 91 and 92.

Upon receiving the Gs gate signal and the Gc gate signal describe above, the dual gate IGBTs 91 and 92 operates to switch between conduction and nonconduction, and thus switching at a low loss and a stable dv_{CE}/dt is enabled.

The power converter 800 of the present embodiment is composed of the drive circuit 63 and the dual gate IGBTs 91 and 92 disposed in the upper and lower arms, and the PWM command signals 89 and 90 are inputted to the upper and lower arms such that conduction and nonconduction of the upper and lower arms can be complementarily controlled, and thus the alternating output wave can be applied to the inductive load 95.

As described above, the sixth embodiment of the present invention shows that the power converter composed of the dual gate IGBTs enables switching at a stable dv_{CE}/dt to the temperature or the current carrying conditions in a low loss performance.

It should be noted that the present invention is applicable to semiconductor devices, drive apparatuses for semiconductor circuits, and power converters widely used ranging from low electric power devices such as air conditioners and microwave ovens to high electric power devices like inverters used in automobiles, railways, iron mills, and any other facilities.

The present invention is not limited to the foregoing embodiments, and includes various exemplary modifications. For example, the foregoing embodiments describe the present invention in detail for easy understanding, and is not necessarily limited to ones including all the configurations described above. Moreover, a part of the configuration of an embodiment can be replaced with the configuration of another embodiment, and the configuration of another embodiment can be added to the configuration of an embodiment. In regard to a part of the configuration of the embodiments, the other configurations may be added, removed, or replaced.

### List of Reference Signs

1: Gs gate signal
2: Gc gate signal (when a device is driven at a high temperature and a high electric current)
3: V_{CE} of dual gate IGBT (when a device is driven at a high temperature and a high electric current)
4: Gc gate signal (when a device is driven at a low temperature and a low electric current)
5: V_{CE}V_{CE} of dual gate IGBT (when a device is driven at a low temperature and a low electric current)
6: turn-on timing
7: turn-off timing
8: ON voltage
9: OFF voltage
10: high voltage
11: 0 V
12: t_{d_on} according to the present invention (when a device is driven at a high temperature and a high electric current)
13: t_{d_off} according to the present invention (when a device is driven at a high temperature and a high electric current)
14: t_{d_on} according to the present invention (when a device is driven at a low temperature and a low electric current)
15: t_{d_off} according to the present invention (when a device is driven at a low temperature and a low electric current)
16: turn-on dv_{CE}/dt according to the present invention (when a device is driven at a high temperature and a high electric current)
17: turn-off dv_{CE}/dt according to the present invention (when a device is driven at a high temperature and a high electric current)
18: turn-on dv_{CE}/dt according to the present invention (when a device is driven at a low temperature and a low electric current)
19: turn-off dv_{CE}/dt according to the present invention (when a device is driven at a low temperature and a low electric current)
20: t_{d_on} according to a comparative example (when a device is driven at a high temperature and a high electric current)
21: t_{d_off} according to a comparative example (when a device is driven at a high temperature and a high electric current)
22: t_{d_on} according to a comparative example (when a device is driven at a low temperature and a low electric current)
23: t_{d_off} according to a comparative example (when a device is driven at a low temperature and a low electric current)
24: turn-on dv_{CE}/dt according to a comparative example (when a device is driven at a high temperature and a high electric current)
25: turn-off dv_{CE}/dt according to a comparative example (when a device is driven at a high temperature and a high electric current)
26: turn-on dv_{CE}/dt according to a comparative example (when a device is driven at a low temperature and a low electric current)
27: turn-off dv_{CE}/dt according to a comparative example (when a device is driven at a low temperature and a low electric current)
28: Gc gate signal
29: t_{d_on} according to the present invention
30: dv_{CE}/dt and a turn-on loss in driving at a high temperature and a high electric current, t_{d_on} dependence
31: dv_{CE}/dt and a turn-on loss in driving at a high temperature and a low electric current, t_{d_on} dependence
32: dv_{CE}/dt and a turn-on loss in driving at a low temperature and a low electric current, t_{d_on} dependence
33: transitions of dv_{CE}/dt and a turn-on loss with changes in the temperature and the drive electric current when t_{d_on} is fixed
34: transitions of dv_{CE}/dt and a turn-on loss with changes in the temperature and the drive electric current when t_{d_on} is varied 35: t_{d_off} according to the present invention
36: dv_{CE}/dt and a turn-off loss in driving at a high temperature and a high electric current, t_{d_off} dependence
37: dv_{CE}/dt and a turn-off loss in driving at a high temperature and a low electric current, t_{d_off} dependence
38: dv_{CE}/dt and a turn-off loss in driving at a low temperature and a low electric current, t_{d_off} dependence
39: transitions of dv_{CE}/dt and a turn-off loss with changes in the temperature and the drive electric current when t_{d_off} is fixed
40: transitions of dv_{CE}/dt and a turn-off loss with changes in the temperature and the drive electric current when t_{d_off} is varied
41: correlation between t_{d_on} and carrier charge time in driving at a high temperature and a high electric current
42: correlation between t_{d_on} and carrier charge time in driving at a high temperature and a low electric current
43: correlation between t_{d_on} and carrier charge time in driving at a low temperature and a low electric current
44: change in carrier charge time with changes in the temperature and the drive electric current when t_{d_on} is fixed
45: change in carrier charge time with changes in the temperature and the drive electric current when t_{d_on} is varied
46: when both sides of Gs and Gc are turned on, at a low temperature
47: when both sides of Gs and Gc are turned on, at a high temperature
48: one side of Gs is turned on, at a low temperature
49: one side of Gs is turned on, at a high temperature
50: correlation between t_{d_off} and carrier discharge time in driving at a high temperature and a high electric current
51: correlation between t_{d_off} and carrier discharge time in driving at a high temperature and a low electric current
52: correlation between t_{d_off} and carrier discharge time in driving at a low temperature and a low electric current
53: change in carrier discharge time with changes in the temperature and the drive electric current when t_{d_off} is fixed
54: change in carrier discharge time with changes in the temperature and the drive electric current when t_{d_off} is varied
55: forward current properties at a low temperature
56: forward current properties at a high temperature
57: ON voltage at low temperature and a low current conduction
58: ON voltage at low temperature and a high current conduction
59: ON voltage at high temperature and a low current conduction
60: ON voltage at high temperature and a high current conduction
61: dual gate IGBT
62: ON voltage of the dual gate IGBT
63: drive circuit
64: programmable integrated circuit (e.g. FPGA)
65: PWM command signal
66: buffer circuit for generating a Gs gate signal
67: buffer circuit for generating a Gc gate signal
68: period in which a current is carried through the dual gate IGBT to generate heat
69: timing of sensing the ON voltage of the dual gate IGBT
70: load set for optimum t_{d_on} and optimum t_{d_off} from a look-up table
71: correspondence table of t_{d_on} and t_{d_off} of a look-up table for ON voltage
72: PWM command signal
73: conduction command pulse duration
74: conduction signal duration for a Gs gate
75: emitter sensing terminal of the dual gate IGBT
76: thermistor
77: temperature information about the dual gate IGBT
78: drive electric current information about the dual gate IGBT
79: electric current detection resistor
80: correspondence table of t_{d_on} and t_{d_off} to the temperature and the drive electric current
81: dual gate IGBT connected to the Gs gate and the Gc gate
82: dual gate IGBT connected to the Gc gate
83: forward properties when both sides of Gs and Gc are turned on
84: forward properties when one side of Gs is turned on (the ratio of the numbers of the Gs gate and the Gc gate 1 : 1)
85: forward properties when one side of Gs is turned on (the ratio of the numbers of the Gs gate and the Gc gate 1: 3 )
86: control width by the Gc gate signal in a structure at the ratio of the numbers of the Gs gate and the Gc gate 1 : 1
87: control width by the Gc gate signal in a structure at ratio of the numbers of the Gs gate and the Gc gate 1 : 3
88: instruction unit
89: PWM command signal line for the upper arm
90: PWM command signal line for the lower arm
91: dual gate IGBT for the upper arm
92: dual gate IGBT for the lower arm
93: diode in anti-parallel connection for the upper arm
94: diode in anti-parallel connection for the lower arm
95: inductive load
96: information about the temperature and the drive electric current of the dual gate IGBT for the upper arm
97: information about the temperature and the drive electric current of the dual gate IGBT for the lower arm
100: electric current-voltage product of the dual gate IGBT
101: turn-off switching loss in the conventional IGBT
102: turn-off switching loss in the dual gate IGBT
103: delay period
104: turn-off dv_{CE}/dt of the conventional IGBT
105: turn-off dv_{CE}/dt of the dual gate IGBT
106: nonconducting period
107: conducting period
164: control circuit
167: drive circuit driving the gate of the IGBT
168: inductive load
169: direct current voltage (electric power) source
170: IGBT
171: insulated gate (terminal) of the IGBT 70
172: diode in anti-parallel connection to the IGBT 70
179: double gate IGBT
180: first gate terminal
181: second gate terminal
182: collector terminal
183: emitter terminal
184: carrier density distribution when the ON signal is applied to the first gate and the OFF signal is applied to the second gate. 185: carrier density distribution when the ON signal is applied to the first gate and the second gate
186: gate signal
187: second gate signal
188: voltage
189: electric current
190: electric current-voltage product
191: time of conduction
192: time of nonconduction
193: threshold voltage of the IGBT
194: power supply voltage
195: collector-emitter voltage of the conventional IGBT
196: collector-emitter voltage of the dual gate IGBT
197: collector electric current of the conventional IGBT
198: collector electric current of the dual gate IGBT
199: electric current-voltage product of the conventional IGBT
200: driving method for the insulated gate (gate controlled) semiconductor device according to the first embodiment
300: driving method for the insulated gate (gate controlled) semiconductor device according to a comparative example
400: insulated gate (gate controlled) state sensing method for the semiconductor device according to the second embodiment
500: driving method for the insulated gate (gate controlled) semiconductor device according to the third embodiment
600: state sensing method for the semiconductor device the insulated gate (gate controlled) according to the fourth embodiment
700: insulated gate (gate controlled) state sensing method for the semiconductor device according to the fifth embodiment
800: according to the sixth embodiment the power converter

## Claims

1. A semiconductor device comprising a dual gate IGBT having a first gate terminal and a second gate terminal,
wherein: at time of transition of the dual gate IGBT from a nonconducting state to a conducting state, to the first gate terminal, a voltage at a threshold voltage or more is applied by a first predetermined time period beforehand from the voltage applying for the second gate terminal;
at time of transition of the dual gate IGBT from a conducting state to a nonconducting state, to the second gate terminal, a voltage less than the threshold voltage is applied by a second predetermined time period beforehand from the voltage applying for the first gate terminal; and
the first predetermined time period and the second predetermined time period are variably controlled such that a time variation in a collector-emitter voltage of the dual gate IGBT is almost constant, the time variation being produced at the time of transition from a nonconducting state to a conducting state and at the time of transition from a conducting state to a nonconducting state.

2. The semiconductor device according to claim 1,
wherein the first predetermined time period and the second predetermined time period are variably controlled suitable for a temperature and an amount of a conducting electric current of the dual gate IGBT.

3. The semiconductor device according to claim 2,
wherein: the first predetermined time period has a relatively small value as the temperature of the dual gate IGBT becomes high and the amount of a conducting electric current becomes high; and
the second predetermined time period has a relatively large value as the temperature of the dual gate IGBT becomes high and the amount of a conducting electric current becomes high.

4. The semiconductor device according to claim 2 or 3,
wherein: a gate signal to be applied to the first gate terminal and the second gate terminal is generated from a PWM command signal that drives an alternating load;
a conduction duration of a gate signal to be applied to the first gate terminal is equal to a conduction duration of the PWM command signal; and
a conduction duration of a gate signal to be applied to the second gate terminal is shorter than a conduction duration of the PWM command signal.

5. The semiconductor device according to any one of claims 2 to 4,
wherein the first predetermined time period and the second predetermined time period are determined by the temperature and the amount of a conducting electric current of the dual gate IGBT in a previous conducting period of the dual gate IGBT.

6. A semiconductor device comprising a first dual gate IGBT and a second dual gate IGBT having two of the dual gate IGBT according to any one of claims 2 to 5 connected in parallel with each other,
wherein: a collector and an emitter of the first dual gate IGBT are connected to a collector and an emitter of the second dual gate IGBT in a shared manner; and
a gate signal to be applied to the second gate terminal of the first dual gate IGBT is applied to both the first gate terminal and the second gate terminal of the second dual gate IGBT.

7. The semiconductor device according to claim 5 or 6, comprising a programmable integrated circuit,
wherein: to the integrated circuit, a correspondence table having a collector-emitter ON voltage, the first predetermined time period, and the second predetermined time period in a conducting period of the dual gate IGBT is programmed; and
based on the first predetermined time period and the second predetermined time period read from the integrated circuit using the collector-emitter ON voltage in a previous conducting period of the dual gate IGBT, a gate signal to be applied to the first gate terminal and the second gate terminal is generated.

8. The semiconductor device according to claim 5 or 6, comprising a programmable integrated circuit,
wherein: to the integrated circuit, a correspondence table having the temperature and the amount of a conducting electric current of the dual gate IGBT and the first predetermined time period and the second predetermined time period are programmed; and
based on the first predetermined time period and the second predetermined time period read from the integrated circuit using the temperature and the amount of a conducting electric current of the dual gate IGBT in a previous conducting period of the dual gate IGBT, a gate signal to be applied to the first gate terminal and the second gate terminal is generated.

9. The semiconductor device according to claim 8,
wherein: as the temperature of the dual gate IGBT, a resistance value of a temperature sensing thermistor connected to an emitter of the dual gate IGBT terminal is used; and
as the amount of a conducting electric current of the dual gate IGBT, a voltage drop value produced from an electric current carried through an emitter sensing terminal of the dual gate IGBT is used.

10. A power converter,
wherein: the semiconductor device according to any one of claims 1 to 9 has a diode in anti-parallel connection to a collector-emitter of the semiconductor device;
a plurality of the semiconductor devices having the diode is connected across direct current terminals in series; and
a connecting point of the semiconductor devices is formed as an alternating terminal.

11. A drive method for a semiconductor device comprising a dual gate IGBT having a first gate terminal and a second gate terminal, the method comprising:
applying, at time of transition of the dual gate IGBT from a nonconducting state to a conducting state, a voltage at a threshold voltage or more to the first gate terminal beforehand by a first predetermined time period from the voltage applying for the second gate terminal;
applying, at time of transition of the dual gate IGBT from a conducting state to a nonconducting state, a voltage less than the threshold voltage to the second gate terminal beforehand by a second predetermined time period from the voltage applying for the first gate terminal; and
variably controlling the first predetermined time period and the second predetermined time period to make a time variation in a collector-emitter voltage of the dual gate IGBT almost constant, the time variation being produced at the time of transition from a nonconducting state to a conducting state and at the time of transition from a conducting state to a nonconducting state.

12. The drive method according to claim 11,
wherein the first predetermined time period and the second predetermined time period are variably controlled suitable for a temperature and an amount of a conducting electric current of the dual gate IGBT.

13. The drive method according to claim 12,
wherein: the first predetermined time period is set to a relatively small value as the temperature of the dual gate IGBT becomes high and the amount of a conducting electric current becomes high; and
the second predetermined time period is set to a relatively large value as the temperature of the dual gate IGBT becomes high and the amount of a conducting electric current becomes high.

14. The drive method according to claim 12 or 13,
wherein: a gate signal to be applied to the first gate terminal and the second gate terminal is generated from a PWM command signal that drives an alternating load;
a conduction duration of a gate signal to be applied to the first gate terminal is equal to a signal duration of the PWM command signal; and
a conduction duration of a gate signal to be applied to the second gate terminal is shorter than a signal duration of the PWM command signal.

15. The drive method according to any one of claims 12 to 14, wherein the first predetermined time period and the second predetermined time period are determined by the temperature and the amount of a conducting electric current of the dual gate IGBT in a previous conducting period of the dual gate IGBT.

16. The drive method according to claim 15,
wherein: a correspondence between a collector-emitter ON voltage and the first predetermined time period and the second predetermined time period in a conducting period of the dual gate IGBT is recorded;
the first predetermined time period and the second predetermined time period are found from the correspondence using the collector-emitter ON voltage in a previous conducting period of the dual gate IGBT; and
based on the first predetermined time period and the second predetermined time period that are found, a gate signal to be applied to the first gate terminal and the second gate terminal is generated.

17. The drive method according to claim 15,
wherein: a correspondence between the temperature and the amount of a conducting electric current of the dual gate IGBT and the first predetermined time period and the second predetermined time period is recorded;
the first predetermined time period and the second predetermined time period are found from the correspondence using the temperature and the amount of a conducting electric current of the dual gate IGBT in a previous conducting period of the dual gate IGBT; and
based on the first predetermined time period and the second predetermined time period that are found, a gate signal to be applied to the first gate terminal and the second gate terminal is generated.
